# EUROPEAN PATENT SPECIFICATION

(11) **EP 0 282 756 B1**
(45) Date of publication and mention of the grant of the patent: **28.09.1994**
(21) Application number: 88102437.6
(22) Date of filing: 19.02.1988
(51) Int. Cl.: C08F 2/38, C08F 8/50, G03F 7/004, C04B 35/00

(54) **Phenyl-endcapped depolymerizable polymer**
Depolymerisierbares Polymer mit Phenylendgruppen
Polymère dépolymérisable avec des groupes phényle terminaux

(30) Priority: 20.03.1987 US 28822
(43) Date of publication of application: 21.09.1988
(73) Proprietor: International Business Machines Corporation, Armonk, N.Y. 10504 (US)
(72) Inventor: Araps, Constance Joan, Wappingers Falls New York 12590 (US); Casey, Jon Alfred, Poughkeepsie New York 12603 (US); Divakaruni, Renuka Shastri, Ridgefield Connecticut 06877 (US); Kandetzke, Steven Michael, Poughkeepsie N.Y. 12603 (US); Lotsko, Catherine Agnes, Beacon New York 12508 (US)
(74) Representative: Colas, Alain

(56) References cited:
- US-A- 4 124 751
- US-A- 4 539 222
- Houben-Weyl, Methoden der organischen Chemie, Vol.14/1 (1961), G. Thieme Verlag Stuttgart, page 1072
- Hendrickson,Cram, Hammond, Organic Chemistry, 3rd Edition (1970), McCraw-Hill New York, page 464

## Description

### Background of the Invention.

The present invention relates to phenyl-endcapped depolymerizable polymers having increased depolymerization threshold temperatures and reduced residue after depolymerization, and their use as lift-off materials and ceramic binders.

Poly(methyl methacrylate) and poly(alpha-methylstyrene) are thermally depolymerizable polymers. These polymers depolymerize by "unzipping," that is they essentially undergo a complete reverse of polymerization, regenerating the gaseous monomer or monomers from which the unzippable polymer was formed.

For use as lift-off materials and binders, an optimal thermally depolymerizable polymer should have the follow ing properties:
1) It should not depolymerize below a given threshold temperature that is above the highest temperature that the structure is exposed to during intermediate process steps.
2) It should not leave any residue after depolymerization.
3) It should have good sheet-forming properties.

Lift-off processes are well known in the art, especially for applying metallization patterns to semi-conductors. In such a process, a sacrificial layer is deposited and patterned with the inverse of the desired metallurgy pattern. Following blanket metallization, the sacrificial layer is dissolved, "lifting off" the metal in the undesired areas. US-A 4.519.872, US-A 4.539.222 and US-A 4.456.675 describe lift-off layers comprising poly(methyl methacrylate) or poly(alpha-methyl styrene). These films undergo rapid weight loss at temperatures of 275-315°C. This creates a problem when argon sputter cleaning at 240°C is used prior to metallization, because the polymers begin to unzip at this temperature.

Binders are normally comprised of simple solvent soluble thermoplastic organic polymers having good film-forming properties which are nonvolatile at moderate temperatures but which will volatilize with other constituents of the resin system on firing of the green sheet to the final sintered state. A commonly used binder resin is poly(vinyl butyral). However, where low temperature systems, such as glass ceramic substrates, are used, the maximum temperature for binder removal is much lower due to the coalescence of the glass particulate at about 800-875°C. Thus, after the glass has coalesced, any remaining binder residue will become entrapped in the glass body. Failure to completely remove the binder in the initial stages of the heat treatment process can result in the evolution of gas during the final sintering stage. This gives rise to pores in the material or, in extreme cases, to blow holes.

Glass ceramic substrates are typically used with copper metallurgy. Copper metallurgy precludes the use of oxidizing ambients during binder burn-off. As disclosed in US-A 4.234.367, it has been found that conventional binder resins, such as poly(vinyl butyral), are not easily burnt out in these non-oxidizing atmospheres. This can result in black or darkened substrates that are not fully sintered. The black or darkened color is generally attributed to carbon residue. The carbon remaining in the ceramic can form conduction paths which lead to lower insulation resistance by many orders of magnitude and to increased dielectric losses.

The use of unzipping polymers such as free radical polymerized poly(methyl methacrylate), poly(alpha-methyl styrene) and polyisobutylene, has been disclosed in IBM Technical Disclosure Bulletin, July 1979, p. 542 to Anderson, et al. and in US-A 4.598.107. These polymers have cleaner burn-out and minimal residue formation in an inert atmosphere as compared to poly(vinyl butyral). A problem with these polymers is that as a result of the free radical polymerization process by which they are formed, there is rather limited control in molecular weight distribution and end groups. Furthermore, the reactive terminal vinyl group promotes cross-linking which leads to carbonaceous residues. This residue will not be removed in low temperature or non-oxidizing systems.

US-A 4.550.061 discloses the use of alpha-substituted styrene polymers or polymers derived from alpha-substituted acrylate monomer as binders for electro-erosion printing media. The materials have decreased residue after decomposition (less than 2%).

US-A 4.474.731 discloses a process for the removal of carbon residues formed during sintering of ceramics.

### Summary of the Invention

It is, therefore, an object of the present invention to improve the materials used for lift-off and as binders.

It is a further object of the invention to increase the depolymerization temperature of the polymers used for lift-off.

It is another object of the invention to eliminate residues produced when depolymerizable polymers unzip.

In accordance with these and other objects, the present invention discloses a depolymerizable polymer formed from the group having the following regular structure 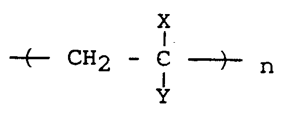
wherein X = CH₃, CN, CF₃ or tert-butyl 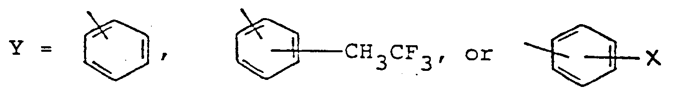
wherein terminal end groups of the polymer have been capped with a phenyl group, and oligopolymers having a molecular weight less than 50,000 have been removed by fractionation

The phenyl endcap eliminates the reactive terminal vinyl group. This decreases the vapor pressure of the bulk polymer at constant temperature and increases the depolymerization temperature. In addition, this eliminates a reactive site from possible reactions which form residues. The phenyl endcap stabilizes the terminal group thermally and quenches the radical/anion on the terminus. If unquenched, the terminal group "quenches" itself via elimination resulting in a terminal vinyl group. 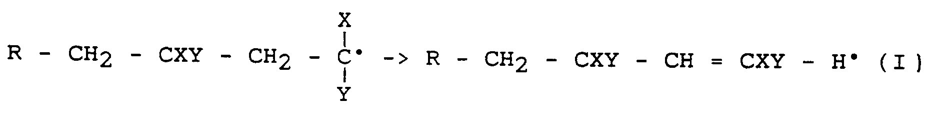
where R=CH3 in this equation as well as in following equations. This vinyl moiety can then become a new site for radical initiation upon heating via H abstraction. The vinyl group is not a thermally stable group. The vapor pressure of the bulk appears to increase upon heating and what results is radically induced chain scission and "unzipping." The unzipping results in volatile byproducts. By contrast, the phenyl-endcapped polymers have increased depolymerization temperatures (by 20-50°C) and decreased residues as compared to the same polymers with out phenyl endcaps.

A mask of the phenyl-endcapped polymer can be applied to a desired substrate, overlaid with a photo-resist, patterned lithographically so as to remove the mask material in the desired pattern areas or vias, and a blanket metallization layer can be applied. Because of the increased depolymerization temperature, the phenyl-endcapped polymer does not unzip during argon sputter cleaning or depo sition of the metallization layer. Upon heating the substrate to a higher temperature than that achieved during sputter cleaning or metallization, the polymer unzips. Adhesion of the blanket metal film is deteriorated sufficiently so that the metal spontaneously delaminates and metal stress causes it to roll up. At this point the metal may be blown away. Alternatively, the depolymerized polymer can be rapidly swelled and/or dissolved in a suitable solvent, due to its substantial reduction in MW and increased solubility of the smaller chain length fragments.

In another application, the phenyl-endcapped polymer can be used as a binder resin in forming ceramic compositions. The phenyl-endcapped polymers according to the present invention have improved "binder burn-out" when compared to such commonly used binders as poly(methyl methacrylate) or poly(vinyl butyral). Binder burn-out is the process step in which the green ceramic is heated to volatilize and remove the binder resin system. During binder burn-out, the phenyl-endcapped polymers decompose uniformly and com pletely, with little or no residue.

### Brief Description of the Drawing

Figs. 1-5 show the lift-off process resulting in metal structures embedded in a passivating layer with a planarized surface.

Fig. 6 shows an alternative embodiment of the lift-off process in which the metal structures are not embedded.

### Description of the Preferred Embodiments

The phenyl endcapping represents a method of stabilizing polymers derived from vinyl monomers. These polymers fall within a class having the following regular structure : 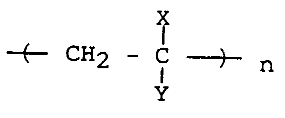
wherein X = CH₃, CN, CF₃ or tert-butyl 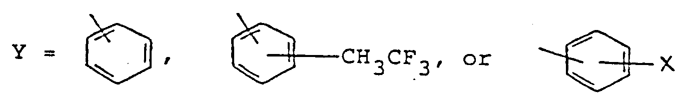
X and Y represent substituents that are thermally stable and cannot be cleaved from the polymer backbone upon heating at conditions as are used in the present invention and n is selected so as to provide the desired molecular weight. Use of a phenyl endcap on such polymers stabilizes the polymer relative to reversal of the polymerization process, i.e. radical depolymerization, or the direct reversal of the reaction mechanism for polymerization. Polymer synthesis and endcapping can be either radical or anionic.

### Preparation of phenyl-endcapped polymers

Synthesis of the polymers can be achieved via either radical or anionic polymerization using a variety of commercially available, common catalysts and/or heat, as is well known in the art :
Radical : 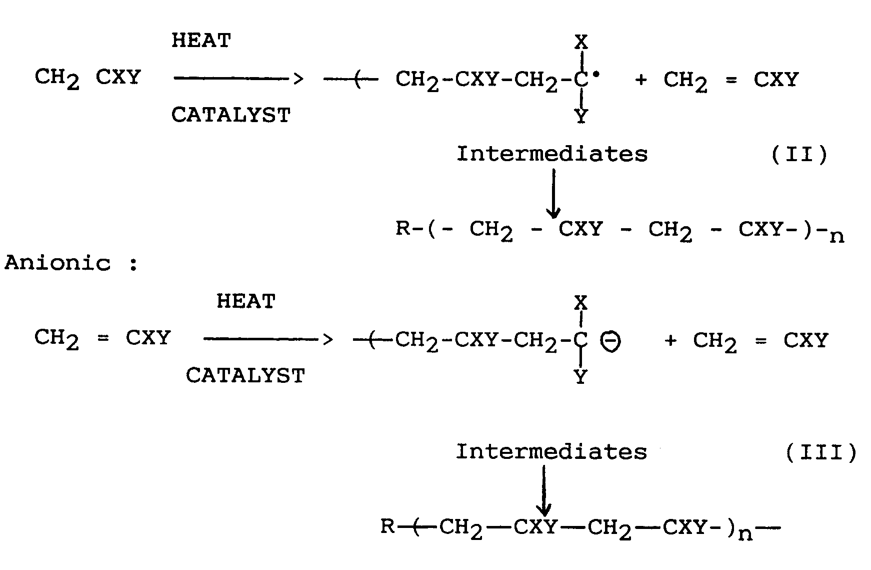
where X=CH₃ and Y=C₆H₅ for poly(alpha-methyl styrene).

Fractionation of the polymer to remove low MW oligomers and impurities will increase the depolymerization tempera ture (TD) of the polymer. Addition of 1% Irganox (Trademark for antioxydants for PVC on the basis of (3.5-di-tert-butyl-4-hydroxyphenylpropionic acid esters of penta-erythrol or of octadecanols) radical trapping agent to scavenge radicals formed prior to main chain polymer depolymerization will also increase T_{D}. Molecular weight of the polymer should be 50,000 to 150,000, with the preferred range being about 60,000 to 90,000.

The endcapping is achieved by quenching the growing, reactive polymer chain with a radical or anionic trapping agent :
Radical : 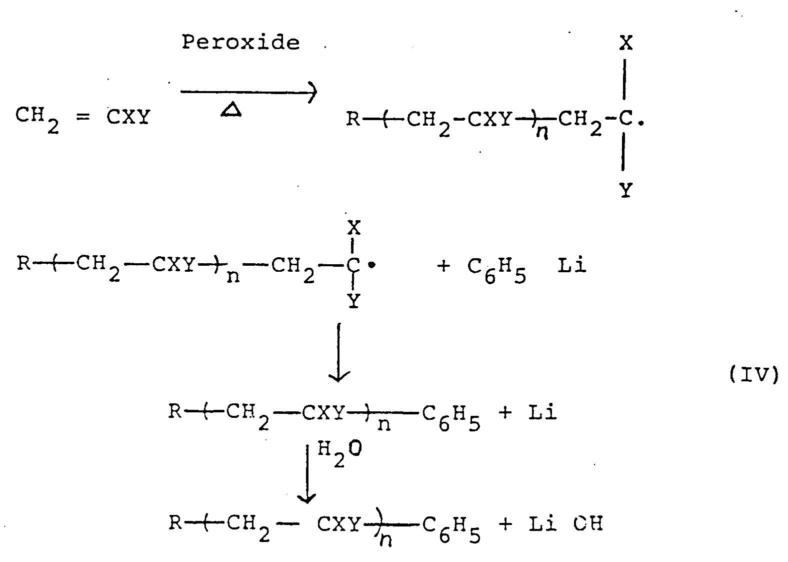
Anionic : 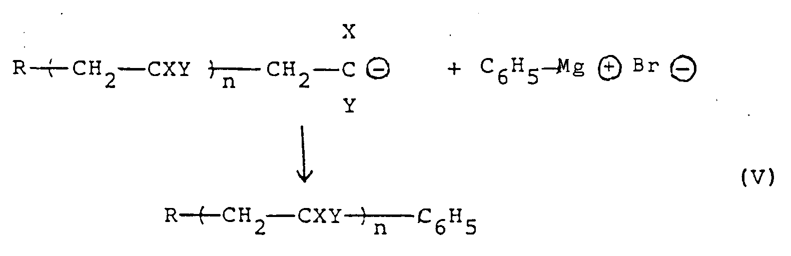
where R, X and Y are as defined above.

### Lift-off process

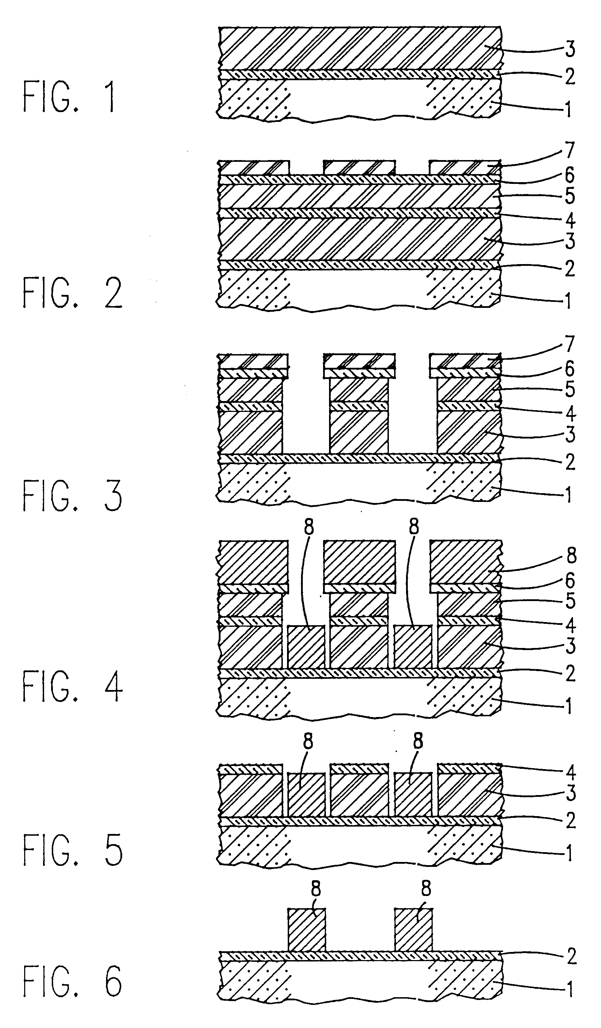

A multilevel metal process using the phenyl-endcapped polymers of the present invention comprises the following generalized sequence of steps.
1. Forming a cured organic polymer layer 3 such as polyimide on a substrate 1 which is typically monocrystalline silicon with a dielectric layer 2 having contact openings (not shown here) for contact with active and passive devices. (Fig. 1) The material for this layer can be the polyimide Pyralin (trademark of E. I. duPont deNemours), which is applied in thicknesses of 1-5 micrometers. For device fabrication the preferred thickness is 1-2 microns while for packaging 4-5 micrometers thick films can be employed. Alternate substrates such as ceramic, glass or other insulating materials can also be employed according to the process described herein to form metallurgy on a module for supporting integrated circuit devices and associated circuitry.
2. Deposition of a thin masking layer 4 by plasma or PECVD (plasma enhanced chemical vapor deposition), e.g., silicon nitride, silicon oxide or plasma polymerized organosilicons. (Fig. 2) Solution coated glass resin type materials may also be used.
3. Application of a layer of the phenyl-endcapped polymer 5 according to the present invention by spin-coating of a 10-40% solution of the polymer in a suitable solvent such as diglyme or 2-methoxy ethyl ether. (Fig. 2) Thickness of the layer will be of the order of 0,5-2,0 micrometers for devices and 5-10 micrometers for packaging. This is followed by a bake cycle of 85°C for 15 minutes or 150-260°C for 1 hour.
4. Deposition of an oxygen reactive ion etch resistant layer 6 as described in Step 2 above, to serve as a barrier during image transfer into the underlying layers by RIE (Reactive Ion Etching) in an O2 containing ambient. (Fig.2)
5. Deposition of a resist layer 7 by spin coating, followed by prebake at an appropriate temperature. The thickness of the film is typically on the order of 1-3 micrometers. (Fig. 2) The resist can be any of those well known in the art, such as AZ 1350J.
6. Exposure and image development of the resist according to techniques well known in the art to delineate the desired metallurgy pattern. (Fig. 2) Depending on the resist, exposure can be by optical, E-beam, X-ray or ion beam.
7. Replication of the resist pattern in the underlying layers by RIE in CF₄ containing ambients to etch the barrier layers and in O₂ containing ambients to etch the lift-off layers. (Fig. 3)
8. Argon sputter cleaning of the substrate at a temperature of 240°C for 6 minutes.
9. Evaporation of a metal layer 8, such as Al/Cu or Cr-Cu-Cr alloy by E-beam or RF evaporation. (Fig. 4) The thickness of layer 8 is preferably approximately equal to that of layer 3.
10. Brief thermal treatment of the metallized structure to depolymerize the phenyl-endcapped polymers. Phenyl-endcapped poly(methyl methacrylate) depolymerizes completely in 3-4 minutes at 350°C or 6-8 minutes at 330°C. T_{D} (the temperature at which depolymerization occurs) is 320°C and no depolymerization is seen at 300°C. Adhesion of the blanket metal film is deteriorated sufficiently so that the metal spontaneously delaminates and metal stress causes it to roll up. At this point the metal may be blown away. Alternatively, solvent assisted lift-off may be used. (Fig.5) If sufficient time is spent above T_{D} the thermal depolymerization can be complete to the point of leaving no residue provided that the polymer was very pure and did not contain any branched groups or residual vinyl groups on the backbone.
11. Steps 1-10 can be repeated to give further levels of metallurgy.

UV analysis has indicated a small shift of 2-5% in the UV absorbance of phenyl-endcapped poly(methyl methacrylate) as compared to unsubstituted poly(methyl methacrylate). Therefore, resist properties and high temperature lift-off properties can be combined in a single 2 micrometers thick film. Taking advantage of this property, Step 5 can be eliminated and the phenyl-endcapped poly(methyl methacrylate) can be directly patterned. In this case, exposure will be by E-beam. This greatly simplifies the lithographic process and permits a totally dry development and lift-off sequence.

Steps 1-10 result in metal structures embedded in a passivating layer with a planarized surface. In an alternative embodiment, Steps 1 and 2 can be eliminated to provide metal structures which are not embedded, as shown in Fig. 6.

### Binder Resin Process

The depolymerizable polymers of the present invention are particularly useful as binder resins in the fabrication of glass ceramic substrate carriers for mounting of semiconductor or integrated circuit chips. Glass ceramics allow sintering at lower temperatures (less than 1000°C) than that possible with alumina-based ceramics, which require sintering temperatures in excess of 1400°C. This allows less refractory metallurgies, such as copper and gold, to be used.

The ceramic slurry for manufacture of ceramic green sheets from glass ceramic is formulated, in accordance with usual practice, from ground glass, a binder resin system and a solvent system. The function of the binder resin system is to provide adhesive and cohesive forces to hold the ground glass together in its green sheet configuration. The solvent system is a volatile composition whose role is to dissolve the binder resin system into solution, to aid in uniformly mixing the binder resin with the ground glass, and to provide the necessary viscosity to the resultant ceramic slurry for subsequent casting. The sintered ground glass forms the substrate material in the ultimately fired structure.

Starting materials for formulation of ceramic slurry in accordance with the present invention comprise liquid solvents (e.g. isopropyl alcohol, acetone), phenyl-endcapped poly(methyl methacrylate) or poly(alpha-methyl styrene) as prepared above, a resin plasticizer (e.g. dibutyl phthalate), and a glass ceramic. Typical glass ceramic can have either beta-spodumene (Li₂.Al₂O₃.4SiO₂) or cordierite (2MgO.2Al₂O₃.5SiO₂) as the main crystalline phase. The general composition ranges for such glass ceramics are described in US-A 4.301.324.

The substrate fabrication process involves the following illustrative basic steps :
1. The cullet of the chosen crystallizable glass is ground to average particle sizes in the range of 2 to 7 micrometers. The grinding can be done in two stages, a preliminary dry or wet grinding to 500 micrometers (through a 400 mesh screen) particle size followed by further grinding with suitable organic binders and solvents until the average particle size is reduced to between 2 and 7 micrometers and a castable slurry is obtained. A single stage prolonged grinding of cullet in the medium of the binder and solvent, until the desired particle sizes are obtained can also be used. In the latter case, a filtering step may be necessary to remove oversized particles.
   The actual quantities of solvent and polymer are chosen to provide the necessary viscosity in the ceramic slurry to form on casting a cohesive ceramic sheet. Generally, this can be obtained by maintaining the ratio, in parts by weight, of the polymer to solvent system in the general range of 1:2 to 1:12, and preferably 1:5 to 1:7. The specific quantity of the solvent system in the ceramic slurry will normally be that which will provide a viscosity in the broad range of about 500 to about 2,000 mPa.s at a temperature of about 25°C, preferably from about 800 to about 1.000 mPa.s at a temperature of about 25°C.
   Generally, the ceramic slurry will comprise from about 40 to about 60 wt. percent of ceramic glass and from about 60 to about 40 wt. percent of binder resin system and solvents. The binder resin system will comprise from about 0-10% plasticizer, with the remainder of the system being phenyl-endcapped polymer and solvents. A preferred embodiment comprises 52,66% ceramic glass, 4,43% phenyl-endcapped polymer, 1,9% dibutyl phthalate, 16,34% isopropyl alcohol and 24,67% acetone.
2. After blending of the ceramic slurry, it is filtered, deaerated and cast on a removable flexible supporting tape, such as Mylar (a glycol terephthalic acid polyester) or Teflon (polytetrafluoroethylene) (both trademarks of E. I. duPont deNemours). The slurry may be slightly compressed, spread and leveled by use of a doctor blade to provide on drying green ceramic sheets having a thickness in the range of 25-400 micronmeters.
3. The cast ceramic slip is dried by evaporation of the solvent system at temperatures providing controlled volatilization in accordance with well-known principles in the art, which minimize e.g. bubbling, cracking, buckling, volatilization of plasticizer, of the drying ceramic slip. The drying temperature is typically 25-50°C and the drying time will be in the range of 1-15 minutes, depending on the thickness of the cast ceramic slip. The air flow during drying is approximately 35 m³/min
4. The resulting green sheet is cut into green sheet units of the desired size and via holes are punched through them in the required configuration. A metallizing paste of copper is extruded into the via holes in the individual sheets.
5. A copper paste or ink is then screen printed on selected units in the patterns desired for electrical conduction. The solvent is evaporated from the coated composition.
6. The green sheet units, after removal of the Mylar supporting tape, are stacked on each other in proper relation. The assembly is then laminated in a laminating press. The temperature and pressure employed for lamination should be such as to cause the individual green sheets to bond to each other and to cause the green ceramic to sufficiently flow and enclose the conductor patterns.
7. After lamination the green laminate is cut to final shape and fired in a furnace under a hydrogen atmosphere for burn-off of the phenyl-endcapped polymer, sintering or coalescence of the glass particles, and conversion to a glass ceramic by crystallization with concurrent sintering of the metal particles in the conductor patterns. Burn-off of the phenyl-endcapped polymer occurred between 250-450°C.

## Claims

1. A depolymerizable polymer formed from the group having the following regular structure 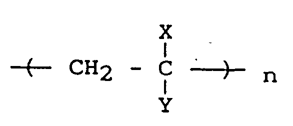 wherein X = CH₃, CN, CF₃ or tert-butyl 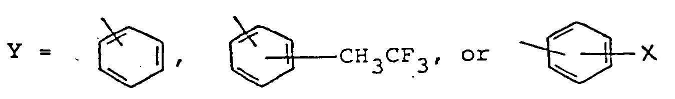 characterized in that terminal end groups of the polymer have been capped with a phenyl group, and oligopolymers having a molecular weight less than 50,000 have been removed by fractionation.

2. The polymer of claim 1 characterized in that it is poly(alpha-methyl styrene).

3. The polymer of Claim 1 orc 2 wherein a radical trapping agent has been added to the polymer.

4. A method for forming a metal pattern on a substrate which comprises the steps of :
depositing over said substrate a blanket layer of a depolymerizable polymer as defined in claim 1, 2 or 3,
patterning said depolymerizable polymer to form a mask complementary to the desired metal pattern,
coating a blanket layer of a conductive metallization over said mask,
thermally depolymerizing said mask, and
removing said depolymerized mask and the metallization thereon.

5. The method according to claim 4 wherein said patterning step further comprises depositing a layer of photoresist and exposing and developing said layer of photoresist.

6. The method according to claim 5 wherein said patterning step further comprises exposure and development of said depolymerizable polymer.

7. The method according to claim 4, 5 or 6 wherein said removal step further comprises cooling said metallic conductive material to delaminate the metal overlying said depolymerized mask.

8. A method for forming a fired ceramic glass which comprises the steps of :
formulating a ceramic slurry by blending a ceramic glass with a depolymerizable polymer as defined in claim 1, 2 or 3 dissolved in a volatile organic solvent; casting said ceramic slurry to form a ceramic slip,
evaporating said organic solvent to form a green sheet, and
heating said green sheet to burn-off said depolymerizable polymers and sinter said ceramic glass.

## Patentansprüche

1. Depolymerisierbares Polymer, das aus der Gruppe mit der folgenden regelmäßigen Struktur gebildet ist: 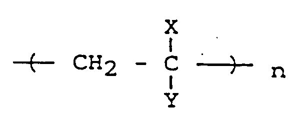 wobei X = CH₃, CN, CF₃ oder tert-Butyl und 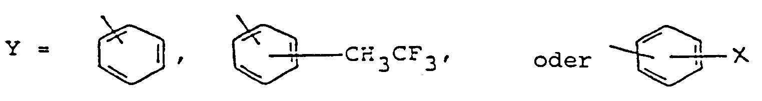 dadurch gekennzeichnet, daß endständige Endgruppen des Polymers mit einer Phenylgruppe abgeschlossen und Oligopolymere mit einem Molekulargewicht von weniger als 50.000 durch Fraktionierung entfernt wurden.

2. Polymer nach Anspruch 1, dadurch gekennzeichnet, daß es Poly-(alpha-Methylstyrol) ist.

3. Polymer nach Anspruch 1 oder 2, wobei ein radikalisches Einfang-Agens zu dem Polymer hinzugefügt wurde.

4. Verfahren zum Erzeugen eines Metallmusters auf einem Substrat mit den Schritten:
Aufbringen einer deckenden Schicht aus einem depolymerisierbaren Polymer nach Anspruch 1, 2 oder 3 über dem Substrat,
Strukturieren des depolymerisierbaren Polymers, um eine zu dem gewünschten Metallmuster komplementäre Maske zu erzeugen,
Aufbringen einer deckenden Schicht aus einer leitfähigen Metallisierung über der Maske,
thermisches Depolymerisieren der Maske und
Entfernen der depolymerisierten Maske und der darauf befindlichen Metallisierung.

5. Verfahren nach Anspruch 4, wobei der Strukturierungsschritt des weiteren das Aufbringen einer Photoresistschicht und das Belichten sowie Entwickeln der Photoresistschicht beinhaltet.

6. Verfahren nach Anspruch 5, wobei der Strukturierungsschritt des weiteren die Belichtung und Entwicklung des depolymerisierbaren Polymers beinhaltet.

7. Verfahren nach Anspruch 4, 5 oder 6, wobei der Entfernungsschritt des weiteren das Abkühlen des metallischen, leitfähigen Materials beinhaltet, um das über der depolymerisierten Maske liegende Metall zu delaminieren.

8. Verfahren zum Erzeugen eines gebrannten keramischen Glases mit den Schritten:
Ansetzen einer Keramikemulsion durch Mischen eines keramischen Glases mit einem in einem leicht flüchtigen organischen Lösungsmittel gelösten depolymerisierbaren Polymer nach Anspruch 1, 2 oder 3; Gießen der Keramikemulsion, um einen Keramikschlicker zu bilden,
Verdampfen des organischen Lösungsmittels, um eine Rohschicht zu bilden, und
Erwärmen der Rohschicht, um die depolymerisierbaren Polymere auszubrennen und das keramische Glas zu sintern.

## Revendications

1. Polymère dépolymérisable formé à partir du groupe ayant la structure régulière suivante: 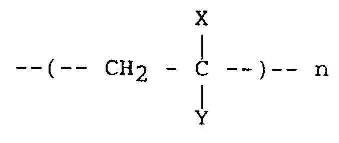 où X = CH₃, CN, CF₃ ou butyl-tert 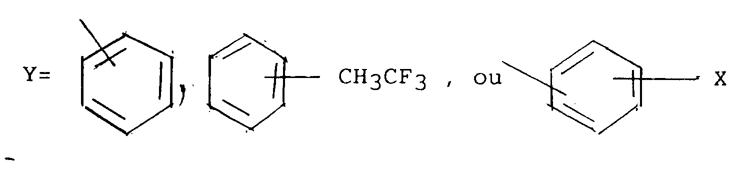 caractérisé en ce que les groupes de terminaisons du polymère ont été recouverts d'un groupe phényle, et des oligopolymères ayant un poids moléculaire inférieur à 50000 ont été enlevés par fractionnement.

2. polymère selon la revendication 1 caractérisé en ce qu'il consiste en un poly(styrène alpha-methyle).

3. polymère selon la revendication 1 ou 2 dans lequel un agent de piégeage de radical a été rajouté au polymère.

4. procédé de formation d'un dessin métallique sur un substrat, comprenant les étapes suivantes:
dépôt sur ledit substrat, d'une couche de couverture d'un polymère dépolymérisable tel que défini dans les revendications 1, 2 ou 3,
modelage dudit polymère dépolymérisable pour former un masque complémentaire du dessin métallique désiré,
réalisation d'une couche de couverture de métal conducteur sur ledit masque,
dépolymérisation thermique dudit masque, et
suppression dudit masque dépolymérisé et de sa métallisation.

5. Procédé selon la revendication 4 dans lequel ladite étape de modelage comprend en outre, le dépôt d'une couche de photorésist ainsi que l'exposition et le développement de ladite couche de photorésist.

6. procédé selon la revendication 5 dans lequel ladite étape de modelage comprend en outre l'exposition et le développement dudit polymère dépolymérisable.

7. Procédé selon la revendication 4, 5 ou 6 dans lequel ladite étape d'enlèvement comprend en outre le refroidissement dudit matériau conducteur métallique pour délaminer le métal recouvrant ledit masque dépolymérisé.

8. Procédé de formation d'un verre céramique cuit comprenant les étapes suivantes:
réalisation d'une pâte céramique par mélange d'un verre céramique avec un polymère dépolymérisable tel que défini dans la revendication 1, 2 ou 3 dissout dans un solvant organique volatile; moulage de ladite pâte céramique pour former une languette de céramique,
évaporation dudit solvant organique pour former une feuille verte, et
chauffage de ladite feuille verte pour brûler lesdits polymères dépolymérisables et fritter ledit verre céramique.
